# EUROPEAN PATENT SPECIFICATION

(11) **EP 3 342 035 B1**
(45) Date of publication and mention of the grant of the patent: **08.06.2022**
(21) Application number: 16806965.6
(22) Date of filing: 11.04.2016
(51) Int. Cl.: H02N 2/18, G01N 27/414, B81B 3/00, H02N 1/08, B81B 7/00

(54) **MICRO-ELECTROMECHANICAL DEVICE, SYSTEM AND METHOD FOR ENERGY HARVESTING AND SENSING**
MIKROELEKTROMECHANISCHE VORRICHTUNG, SYSTEM UND VERFAHREN ZUR ENERGIEGEWINNUNG UND MESSUNG
DISPOSITIF MICROÉLECTROMÉCANIQUE, SYSTÈME ET PROCÉDÉ POUR COLLECTE ET DÉTECTION D'ÉNERGIE

(30) Priority: 11.06.2015 US 201562230622 P
(43) Date of publication of application: 04.07.2018
(73) Proprietor: Enervibe Ltd., 88820 Hevel Eilot Regional Council (IL)
(72) Inventor: HARONIAN, Dan, 9043500 Efrat (IL)
(74) Representative: Lapienis, Juozas
(86) International application number: PCT/IB2016/052040
(87) International publication number: WO 2016/198968

(56) References cited:
- US-A1- 2002 014 660
- US-A1- 2004 197 227
- US-A1- 2004 253 787
- US-A1- 2005 093 380
- US-A1- 2013 106 497
- US-A1- 2014 352 775
- US-B1- 6 597 048

## Description

### TECHNICAL FIELD

The present disclosure relates to micro-electromechanical systems, devices and methods for harvesting electrical energy from mechanical movements as well as for use as chemical and displacement sensors.

### BACKGROUND

Micro-electromechanical devices and systems utilize piezoelectric, electromagnetic or electrostatic converters for converting mechanical movement into electrical energy.

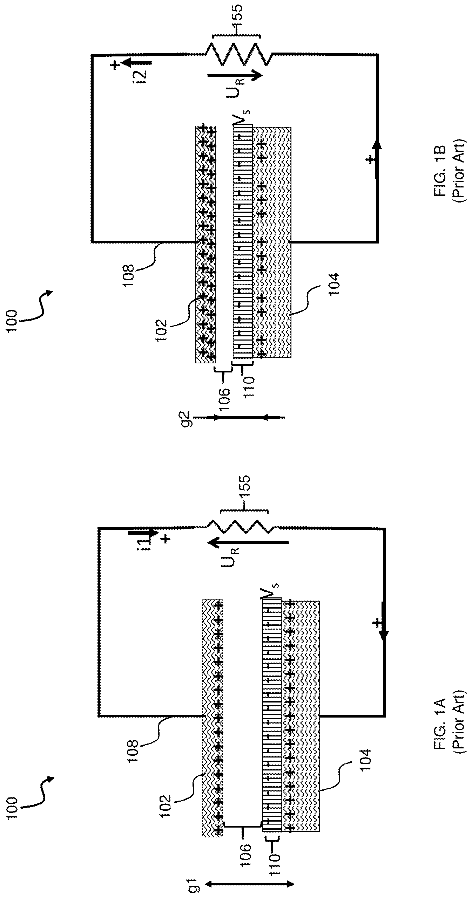

As shown schematically in **FIGS. 1A** and **1B**, a known electrostatic converter **100** has a variable capacitor structure comprising a first and a second capacitor plate **102** and **104** separated by a dielectric **106** (e.g., air) and which are conductively coupled with each other over a conductor **108** having a resistivity or load **155** having an impedance **Z**. An electret layer **110** is formed on, or constitutes either first capacitor plate **102** or second capacitor plate **104** such as to face the other plate. The electret can be made of SiO₂ and is charged with electrons, for example, by using corona. Further, first and/or second capacitor plates **102** and **104** are mounted to allow alternatingly retracting and approaching movements which, in turn, induces alternating (AC) electric current in conductor **108**. Relative retracting and approaching movements of first and second capacitors plates **102** and **104** are schematically illustrated by arrows **g1** and **g2**. For example, first capacitor plate **102** may be moveably mounted (e.g., suspended) to allow its displacement responsive to mechanical vibrations in approaching and retracting directions **g1** and **g2** relative to second capacitor plate **104** which may be fixed in space. Another possibility is a device configuration in which the gap between the electrodes remains substantially constant yet which oscillate sideways so that the amount of electrode overlap changes periodically. The induced AC may be rectified by rectifier circuitry to generate a direct current (DC), e.g., for charging batteries or powering an electrical device.

If a distance between first and second plates **102** and **104** due to relative displacement in direction **G1** is large enough, the charge on the capacitors is redistributed and the electric current flows as schematically illustrated in **FIG. 1A** by arrow **i1**. Conversely, if a distance between first and second plates **102** and **104** decreases due to relative approaching displacement in direction **D2**, then the electric current flows as schematically illustrated in **FIG. 1B** by arrow **i2.**

Electrostatic converters that employ electrets are disclosed exemplarily by T. Tsutsumino, Y. Suzuki, N. Kasagi, K. Kashiwagi, Y. Morizawa in "Efficiency Evaluation of Micro Seismic Electret Power Generator", Proceedings of the 23rd Sensor Symposium 2006, Takamatsu, pp. 521-524; by Ma Wei, Zhu Ruiqing, Rufer Libor, Zohar Yitshak, Wong Man in "An integrated floating-electrode electric microgenerator", Journal of microelectromechanical systems, v. 16, (1), 2007, FEB, p. 29-37; and in United States Patent 8796902 to TATSUAKIRA et al. titled "Electrostatic Induction Power Generator".

The lifetime of a known electrostatic converter such as converter **100** depends, *inter alia*, on the charge stability implanted inside the electret.

The description above is presented as a general overview of related art in this field and should not be construed as an admission that any of the information it contains constitutes prior art against the present patent application. US 6,597,048 B1 discloses an electrostatically charged microstructure to reduce friction and wear. Repulsive forces are induced between movable membranes and surrounding electrodes by charging both the membrane and the surrounding electrodes with the same charge. The charging is provided by coupling the moving membrane and the surrounding electrodes to the floating gate of an EEPROM. As a result, repulsive forces between the adjacent electrodes and the membrane are created, thereby allowing tuning of the resonance frequency of the resonator. The vibrating membrane acts as a passive element and induces waveforms in the surrounding conductors. To further increase the effectiveness of the device, nano-crystal floating gate structures may be employed to reduce an effect of mirror charges in the moving membrane and to avoid redistribution of charges.

### SUMMARY

The invention as defined in the claims relates to a micro-electromechanical device (MEMD) for sensing and for harvesting electrical energy responsive to being subjected to mechanical forces, comprising: at least one first conductive element fixedly mounted on a first support, wherein the at least one first conductive element is chargeable with electrons; and at least one second conductive element which is inertia-mounted on a second support such that the first and second supports are electrically isolated from each other.

The MEMD comprises a floating gate charging device (FGCD) having a tunnel oxide, the floating gate charging device used for charging the at least one first fixedly mounted conductive element selectively and controllably by tunneling electrons through the tunnel oxide into the at least one first fixedly mounted conductive element.

The MEMD further comprises an electronic circuit operably coupled with the at least one inertia-mounted second inertia-mounted conductive element for reading out charge displacement in the at least one second inertia-mounted conductive element resulting from relative movement between the at least one first fixedly mounted conductive element and the at least one second inertia-mounted conductive element.

Optionally, the FGCD further comprises a source and drain for tunneling hot electrons to a floating gate of the FGCD responsive to applying a voltage between the source and the drain.

Optionally, the FGCD has a charging polarity and a discharging polarity, wherein the discharging polarity is used to drain the electrons out of the at least one first fixedly mounted conductive element.

Optionally, the MEMD comprises a plurality of FGCDs such that each FGCD charges one or more first fixedly mounted conductive elements.

Optionally, the MEMD comprises a plurality of first fixedly mounted conductive elements that are electrically isolated from each other.

Optionally, the MEMD comprises a plurality of first fixedly mounted conductive elements electrically conductively coupled with each other.

Optionally, the induced electrons displacement is rectified for the charging of a battery or the powering of an electrical device.

Optionally, the induced electrons displacement is measured for obtaining a value indicative of a displacement of the MEMD.

Optionally, the at least one first fixedly mounted conductive element is highly doped with Donors atoms to form N type silicon.

Optionally, the at least one first fixedly mounted conductive element is highly doped with Acceptors atoms to form P type silicon such that the charging electrons recombine with holes such that the first fixedly mounted conductive element is charged by negatively charged Acceptor ions.

The invention relates also to a method of fabricating the MEMD such that the at least one first fixedly mounted conductive element, the at least one second inertia-mounted conductive element and the FGCD are fabricated on a single wafer such that first fixedly mounted conductive element, the at least one second conductive inertia-mounted element and the FGCD are electrically isolated from each other while the floating gate of FGCD is electrically coupled with the first fixedly mounted conductive element.

Aspects of embodiments may also relate to a method for charging the MEMD. Optionally, the charging or discharging includes a plurality of charging or discharging cycles.

Optionally, each charging or discharging cycle may take less than one second.

### BRIEF DESCRIPTION OF THE FIGURES

The figures illustrate generally, by way of example but not by way of limitation, various embodiments discussed in the present disclosure.

For simplicity and clarity of illustration, elements shown in the figures have not necessarily been drawn to scale. For example, the dimensions of some of the elements may be exaggerated relative to other elements. Furthermore, reference numerals may be repeated among the figures to indicate corresponding or analogous elements. The figures are listed below.
**FIG. 1A** is a schematic circuit diagram illustration of a MEMD showing retracting conductive elements, as known in the art;
**FIG. 1B** is a schematic circuit diagram illustration of the MEMD showing approaching conductive element, as known in the art;
**FIG. 2A** is a schematic perspective view of a MEMD, according to an embodiment;
**FIG. 2B** is a schematic top plan view illustration of the MEMD of **FIG. 2A**;
**FIG. 3A** is a schematic perspective view of an MEMD, according to another embodiment;
**FIG. 3B** is a schematic top plan view illustration of the MEMD of **FIG. 3A**;
**FIG. 3C** is a schematic top plan view illustration of an MEMD, according to an alternative embodiment;
**FIG. 3D** is a schematic perspective view of an MEMD, according to a yet other embodiment;
**FIG. 3E** is a schematic perspective view of an MEMD, according to a yet alternative embodiment;
**FIG. 4A** is a schematic perspective side view illustration of a charging arrangement, according to an embodiment;
**FIG. 4B** is a schematic perspective front view illustration of a charging arrangement, according to another embodiment;
**FIG. 4C** is a schematic top plan view illustration of the charging arrangement of **FIG. 4B**;
**FIG. 5A** is a schematic side view illustration of a charging arrangement and the electron tunneling path, according to an embodiment;
**FIG. 5B-1** is a schematic side view illustration of a charging arrangement showing a first charge distribution stage;

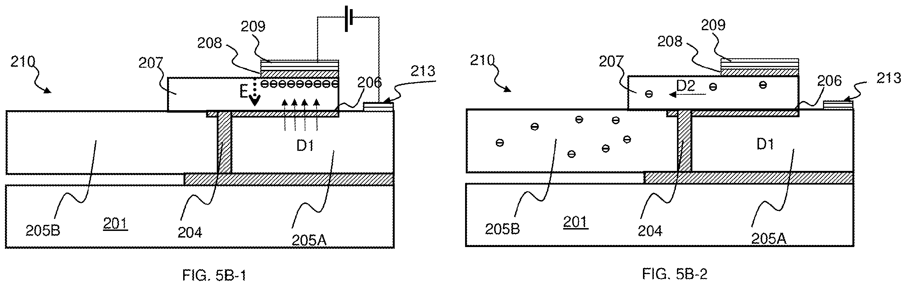

**FIG. 5B-2** is a schematic side view illustration of a charging arrangement showing a later, second charge distribution stage;

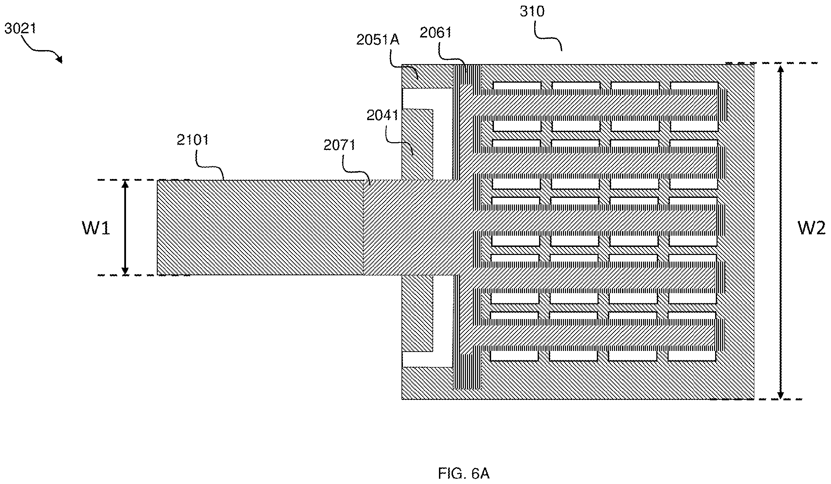

**FIG. 6A** is a schematic top plan view illustration of a charging arrangement, according a yet other embodiment;

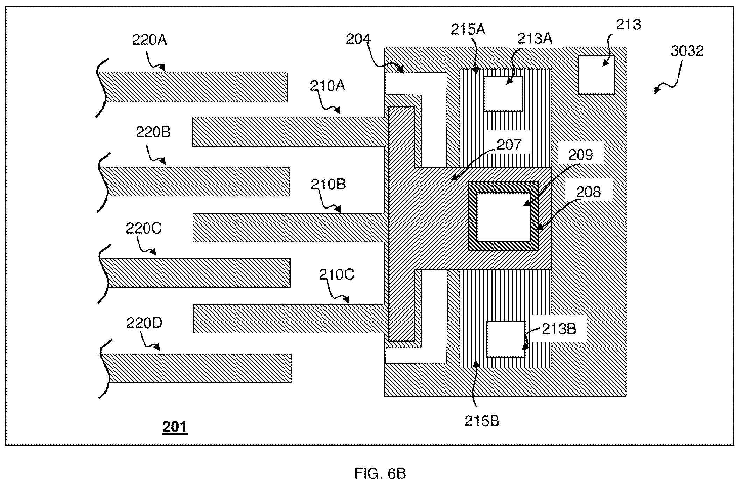

**FIG. 6B** is a schematic top plan view illustration of a charging arrangement, shown one floating gate charging device charging a plurality of first charged element according to other embodiment;

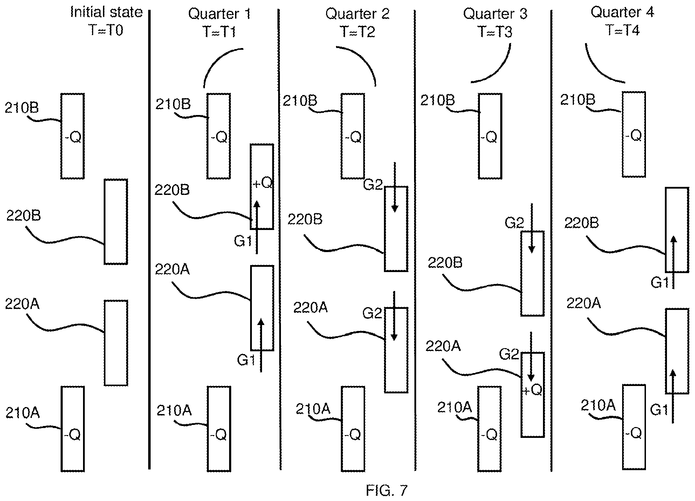

**FIG. 7** is a sequence diagram of the behavior of charge carriers in conductive element, according to an embodiment;

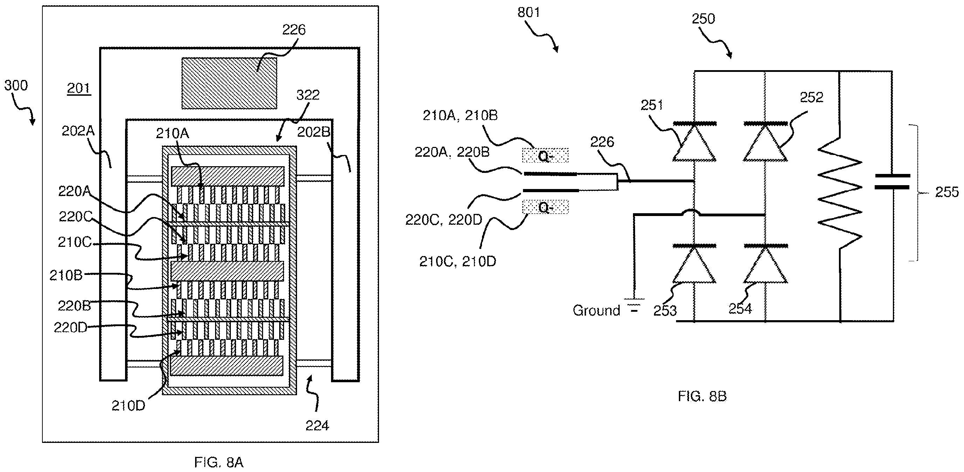

**FIG. 8A** is a schematic top plan view illustration of an MEMD, according to a further alternative embodiment;
**FIG. 8B** is a circuit diagram representing the functional electronic elements of the MEMD of **FIG. 8A**;

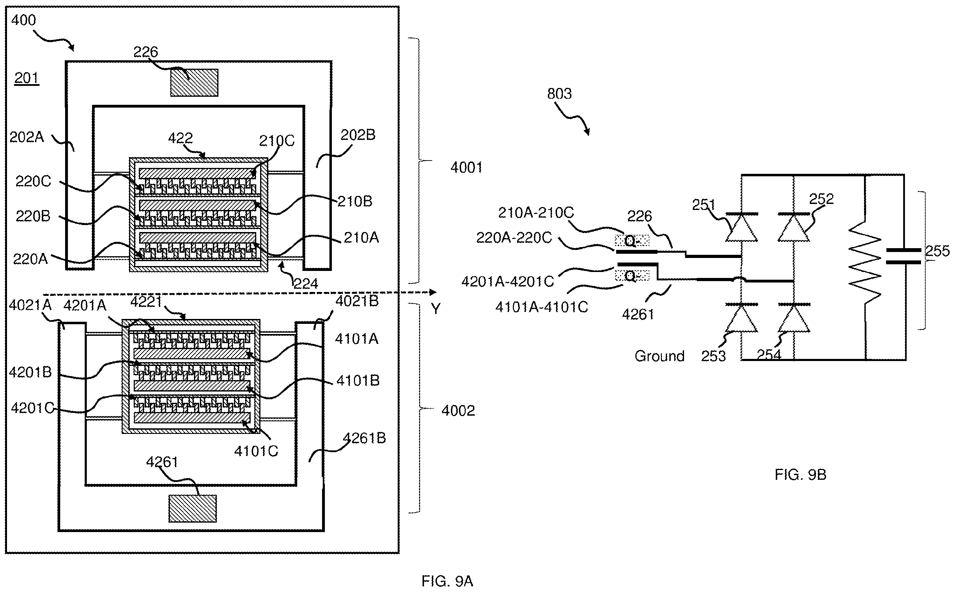

**FIG. 9A** is a schematic top plan view illustration of a combination MEMD, according to an embodiment;
**FIG. 9B** is a circuit diagram representing the functional electronic elements of the combination MEMD of **FIG. 9A**;

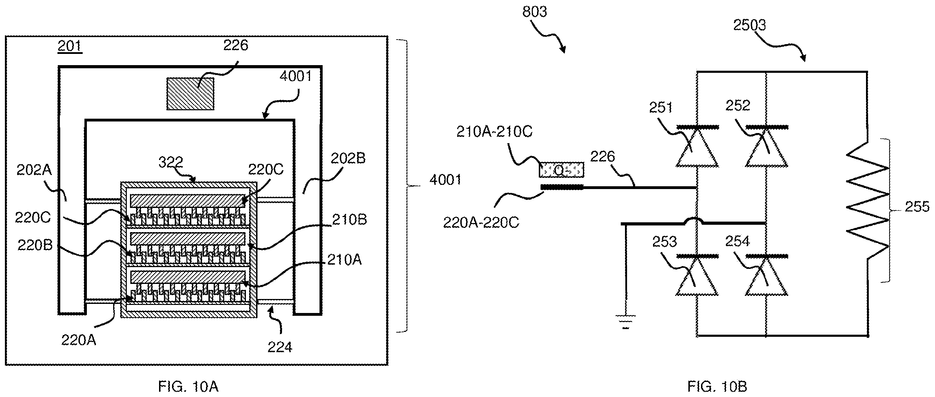

**FIG. 10A** is a schematic top plan view illustration of a yet another alternative MEMD, according to an embodiment;
**FIG. 10B** is a circuit diagram representing the functional electronic elements of the MEMD of **FIG. 10A**;

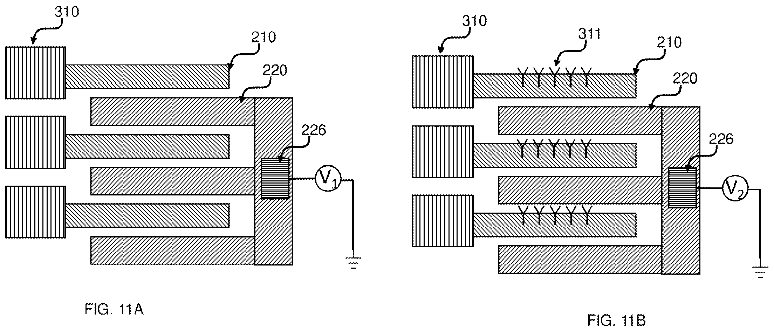

**FIG. 11A** is a schematic top view illustration of a sensing MEMD in an inactive mode, according to an embodiment;
**FIG. 11B** is a schematic top view illustration of the sensing MEMD in an active mode; and

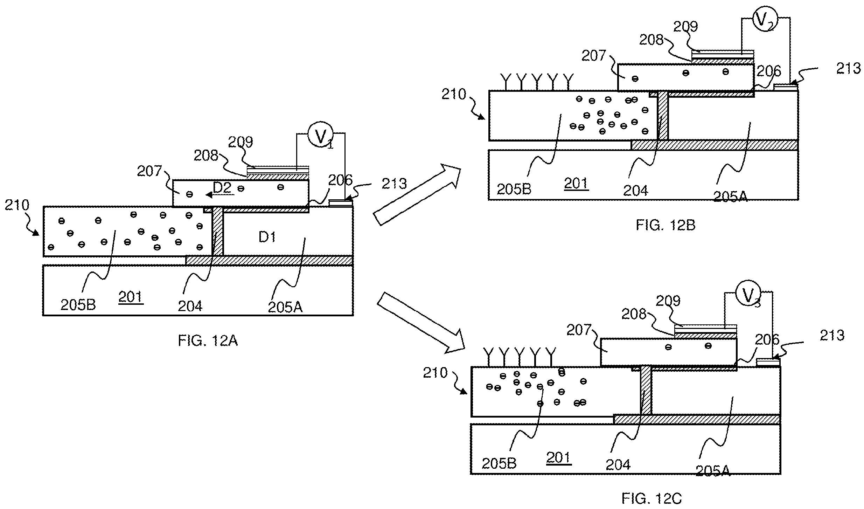

**FIG. 12A** **-12C** show schematic side view illustrations of a charging arrangement at various sensing stages of the sensing MEMD of **FIGS. 11A****-11B**.

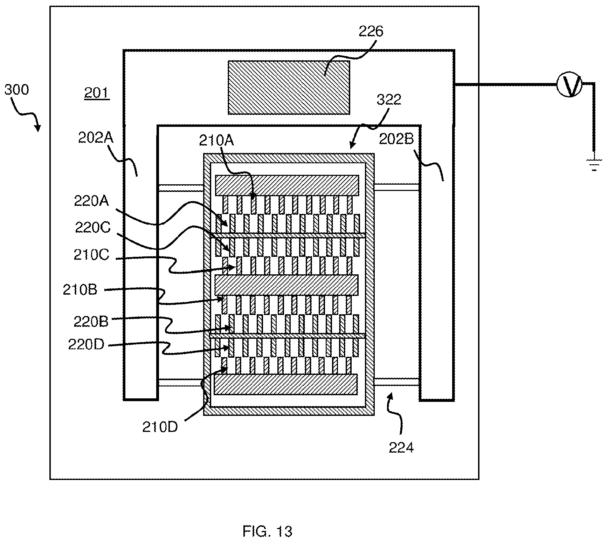

**FIG. 13** describes a displacement sensor, according to an embodiment;

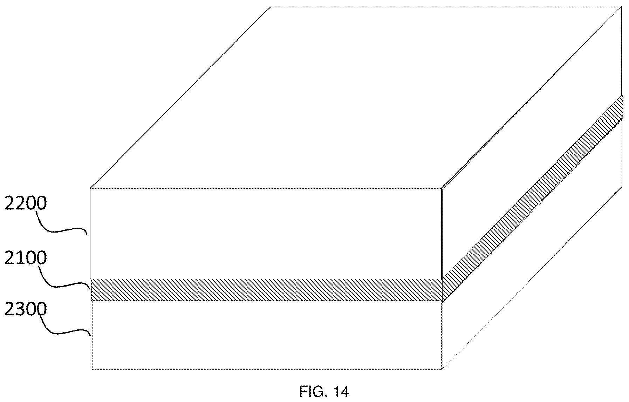

**FIG. 14** describes one stage in a method for manufacturing a charging arrangement, according to an embodiment;

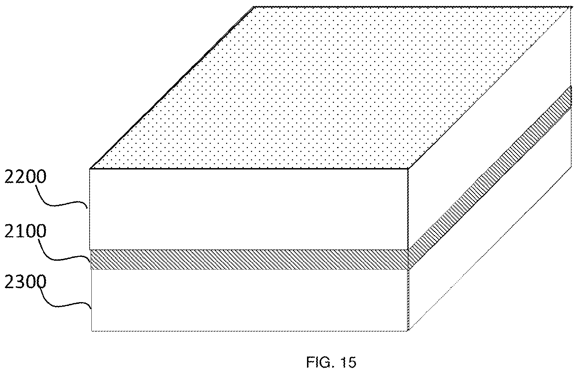

**FIG. 15** describes another stage in a method for manufacturing a charging arrangement, according to an embodiment;

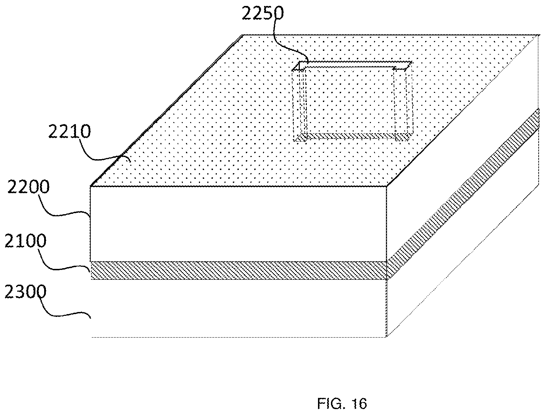

**FIG. 16** describes yet another stage in a method for manufacturing a charging arrangement, according to an embodiment;

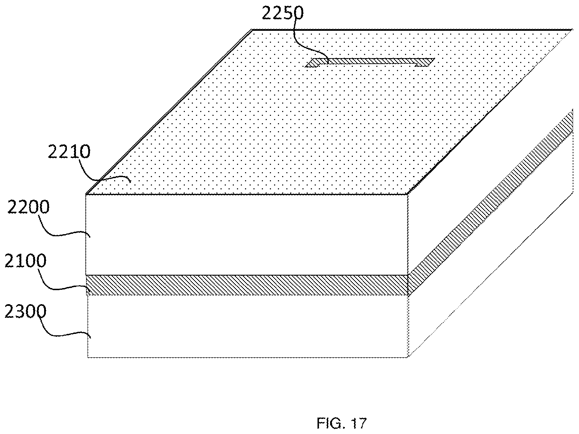

**FIG. 17** describes yet another stage in a method for manufacturing a charging arrangement, according to an embodiment;

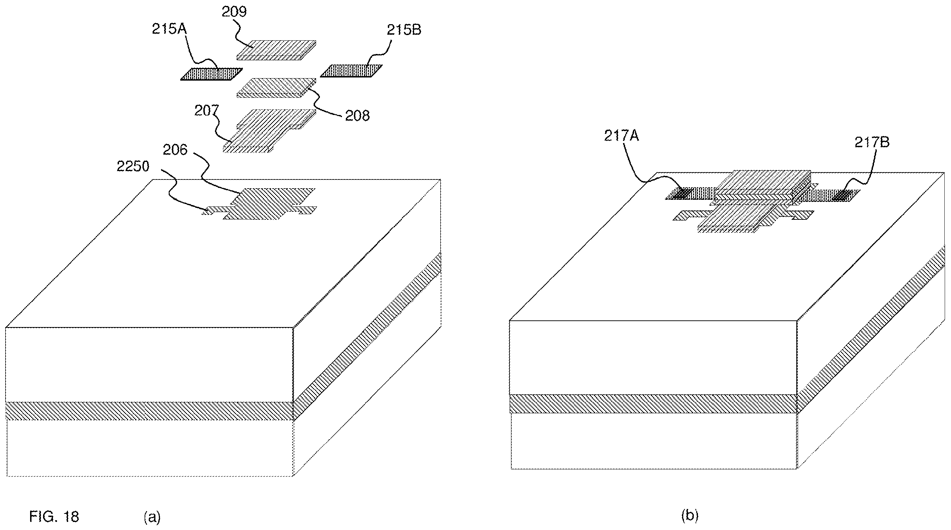

**FIG. 18** describes a stage in a manufacturing process for obtaining a FGCD that is integrated with a first conductive element, according to an embodiment;

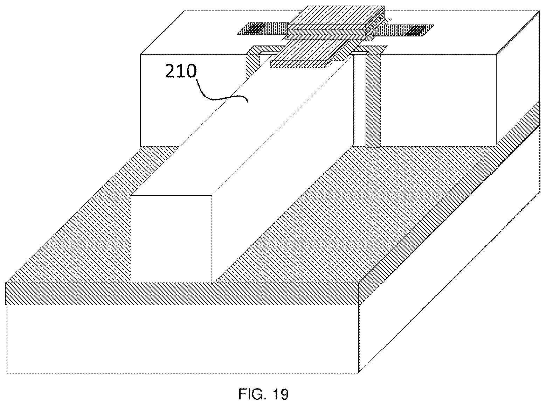

**FIG. 19** describes another stage in a manufacturing process for obtaining a FGCD that is integrated with a first conductive element, according to an embodiment;

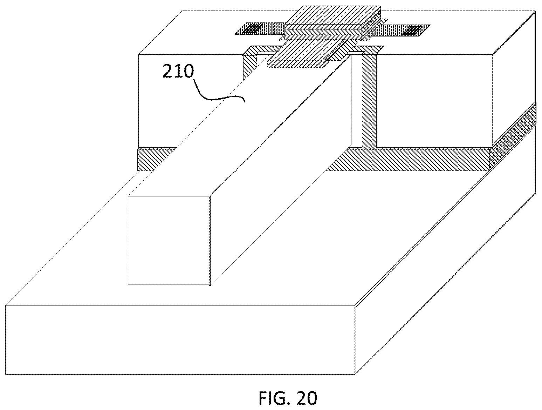

**FIG. 20** describes yet another stage in a manufacturing process for obtaining a FGCD that is integrated with a first conductive element, according to an embodiment;

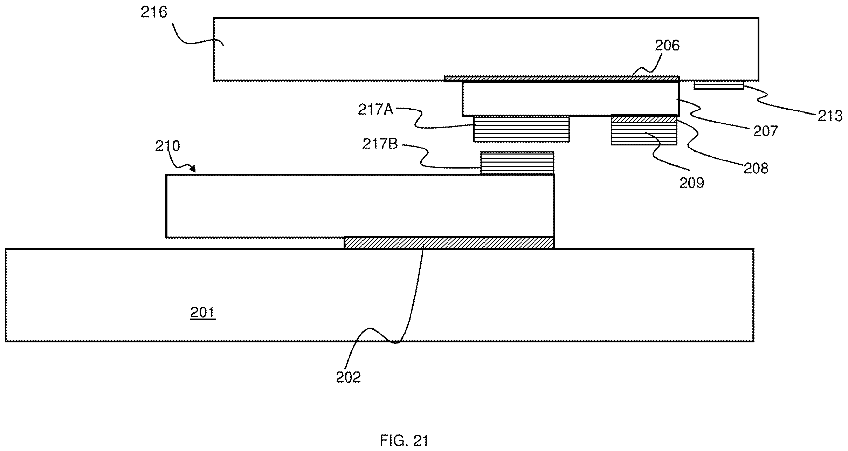

**FIG. 21** describes another example of a fabrication process of a MEMD, according to an embodiment.

### DETAILED DESCRIPTION

The following description of Micro-Electro-Mechanical Devices (MEMD), systems and methods for energy harvesting and/or sensing is given with reference to particular examples, with the understanding that such devices, systems and methods are not limited to these examples.

The expression "energy harvesting" as used herein, as well as grammatical variations thereof, refers to the conversion of mechanical motion into electric energy. Such mechanical motion may the result of acceleration and/or vibration on an MEMD according to embodiments. Accordingly, an MEMD according to an embodiment may function as a displacement sensor. Vibrations may be periodic or random or result from forces such as Coriolis force in MEMD gyroscopes. In some embodiments, an MEMD may be employed for energy harvesting. Sensed mechanical motion may be desirable or undesirable ("wasting energy"). Sources of undesirable vibration include, for example, vibrational motions of engines, friction, movement of a tire on a road, walking, mammalian organ and vascular movement, etc.

A micro-electromechanical device (MEMD) includes according to some embodiments one or more first electrically conductive element that are electrically isolated from their surroundings and are selectively electrically chargeable in a controlled manner, and one or more second electrically conductive elements that are electrically isolated from the first member(s). Furthermore, the first conductive elements may also be electrically isolated from one another. The first conductive element can be selectively charged independent of the amount of overlap and/or proximity between the first conductive element and the second inertia-mounted elements.

Merely to simplify the discussion that follows, without it being construed as limiting, the first and second conductive element(s) are each herein referred to in the plural, i.e., as "conductive elements".

The first conductive elements may be made of any suitable solid state material including, for example, silicon. The first conductive element(s) may be selectively electrically chargeable by employing for example a floating gate charging device (FGCD) that may charge the first conductive element by tunnelling electrons through a thin layer of oxide. In some embodiments, corona charging and/or electron-beam charging techniques may be employed.

The first and/or second conductive elements are oscillatingly mounted to allow them to alternatingly approach and move away from each other when the MEMD is subjected to vibration forces of sufficiently high magnitude. Responsive to the conductive elements movement relative to each other, an alternating current is induced in the MEMD. In one embodiment, either the first or the second conductive elements are coupled with, or constitute an inertia-mounted conductive element. The expression "inertia-mounted" on a support means a conductive element which is mounted such as to be less responsive to a change in external forces compared to being "fixedly mounted" on the support. Hence, when one conductive element is inertia-mounted and another conductive element is "fixedly-mounted" on the same support, and the support is subjected to mechanical forces of sufficient magnitude, relative movement occurs between the inertia-mounted and fixedly-mounted conductive elements. For simplicity, these elements are sometimes referred to herein as "fixed elements" and "inertia elements".

According to the invention, the first conductive elements may be part of a charging arrangement, as outlined and exemplified in more detail herein below. The first conductive elements are isolated from the second conductive elements and from the substrate. The second conductive elements are connected to an electrical circuit so that charge movement therein is induced upon relative movement between the first and second conductive elements. In some embodiments, a floating gate charging device may be employed to charge an electret. In another embodiment, the MEMD may be operable while being electret-free. Moreover, in some embodiments, the MEMD may be configured and operative so that first conductive elements are selectively rechargeable and/or drainable of their electric charge. According to some embodiments, the first conductive elements may be charged after completion of MEMD packaging and/or close to the use of the MEMD, for example, in less than 1 second or in less than 0.5 seconds. Standard fabrication technologies can be used to manufacture MEMD(s) disclosed herein while improving device usability and its compatibility with state of the art VLSI.

In an embodiment, the first and second conductive elements may, for example, be manufactured using a Silicon-on-Insulator (SOI) wafer (e.g., a silicon carry wafer coated by thin layer of oxide and on top of it bonded silicon layer), or a Silicon on Glass (SOG) wafer.

The expression "electrically isolated" with respect to the "first conductive element(s)" as used herein may refer to a state in which the first conductive element(s), under normal operating conditions, are electrically isolated from the wafer substrate, e.g., through an oxide layer and from each other by space. Such normal conditions exclude the application of electron leakage from the first conductive element to the substrate or to the other conductive element from which the first conductive element is isolated, for example, by air, inert gas, or vacuum. The separation distance may be in the order of microns. It is noted that a conductive element may be considered to be electrically isolated even when it can be charged using a FGCD using a proper tunneling setup or using corona charging.

The first and the second conductive elements are configured and arranged relative to each other such to enable relative motion between the conductive elements, e.g., responsive to subjecting the MEMD to vibrational motion. The first and second conductive elements alternatingly move in an approaching and retracting movement relative to each other such to induce an electrical current in the associated circuit. Otherwise stated, the gap between the first and second conductive elements may oscillatingly decrease and increase. In another example, the first conductive elements and the second conductive elements may be arranged to enable them, in operation, to alternatingly move sideways relative to each other such that the overlapping area changes instead of the gap between the two conductive elements.

When the MEMD is subjected to forces which cause the conductive elements to alternatingly move relative to each other to induce electric current, the MEMD is considered to be "in operation" or "in an operative state". Conversely, when the MEMD is not subjected to operative forces the MEMD is considered to be at "rest".

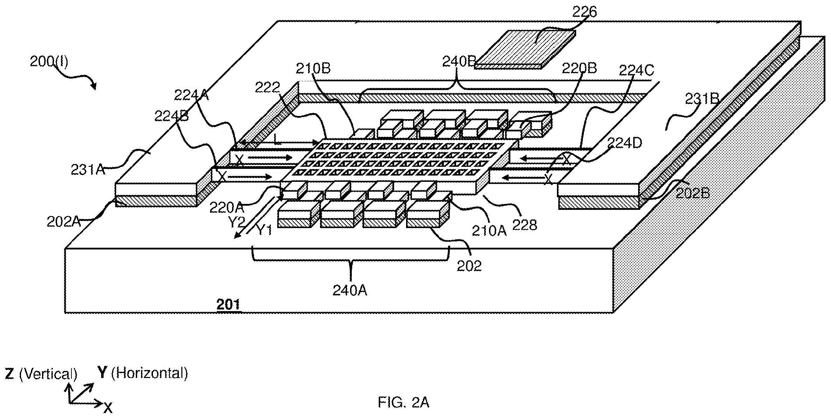

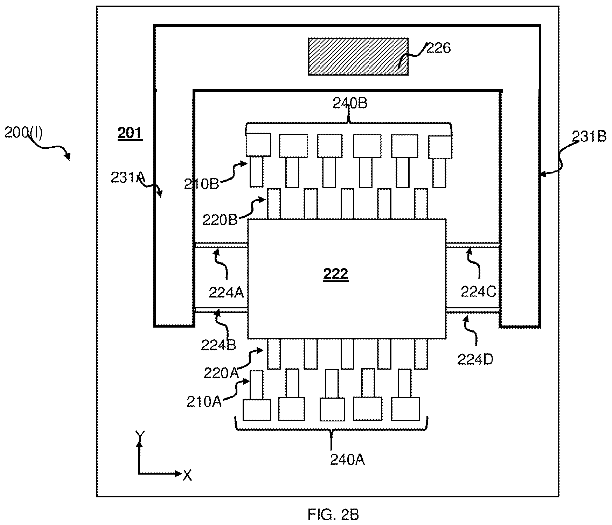

Reference is made to **FIG. 2A**, which schematically illustrates a perspective view of a MEMD **200(I)**; and to **FIG 2B**, which schematically illustrates a top planar view illustration of MEMD **200(I)** according to the embodiment shown in **FIG. 2A**. In MEMD **200(I)** shown in **FIGS. 2A** and **2B**, each one of conductive elements **210A** are electrically isolated from each other.

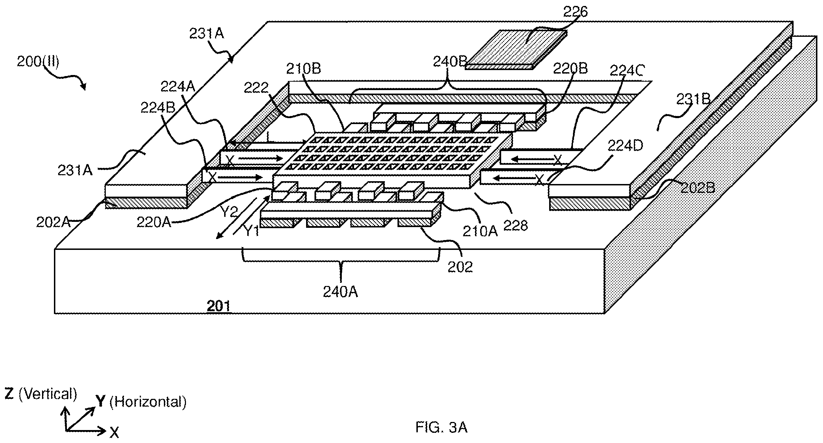

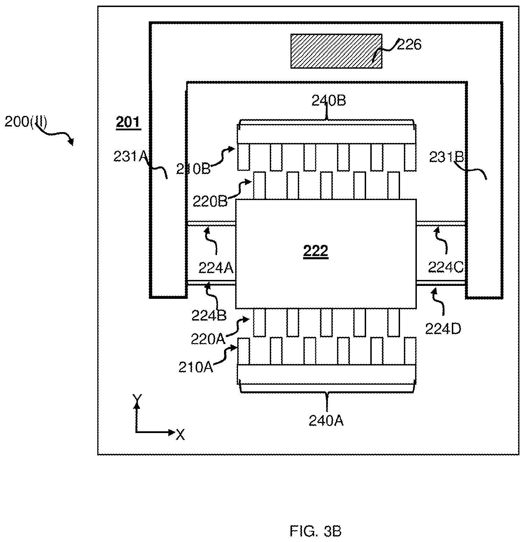

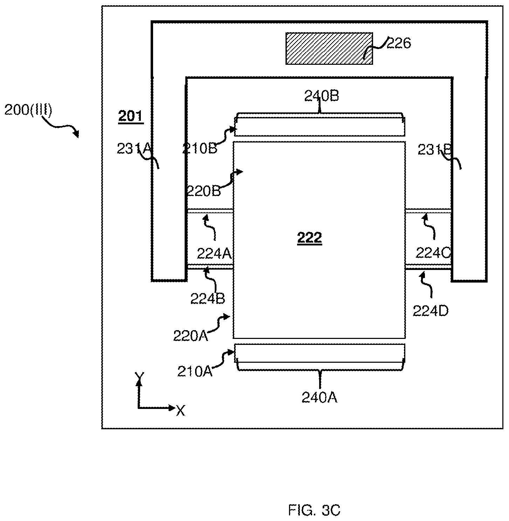

In MEMD **200(I)**, each conductive element **210** has to be charged individually. Moreover, reference is made to **FIG. 3A**, which schematically illustrates a perspective of a MEMD **200(II)**; and to **FIG. 3B**, which schematically illustrates a top planar view of MEMD **200(11),** according to the embodiment of **FIG. 3A**. In MEMD **200(II)**, shown in **FIGS. 3A** and **3B****,** conductive elements **210A** are conductively coupled with each other. Accordingly, in MEMD **200(11),** conductive elements **210** can be charged from any point on the conductive element as the charging electrons diffuse across the element. In addition, the electrons may distance themselves from each other and end up occupying the periphery of the volume of the material of the first conductive element, i.e., close to the elements' surfaces.

As shown schematically in **FIGS. 2A** to **3C**, in an embodiment, with respective reference to a first side **240A** and a second side **240B** of MEMD **200**, first fixedly mounted conductive elements **210A** and **210B** and oscillating conductive elements **220A** and **220B** may be arranged in a laterally interlacing manner to form a comb-like structure. For instance, in one embodiment, as shown in **FIG. 3A** when proceeding in the **X**-direction along first side **240A**, a first conductive element **210** is followed by a second conductive element **220**, which is again followed by another first conductive element **210**, etc., or vice versa.

In another instance exemplified by a MEMD **200(III)**, a single first conductive element **210** and a single second conductive element **220** may have straight surfaces facing each other. As shown in **FIGS. 2A****-3C**, support members **231A** and **231B** are legs of a U-shaped support structure.

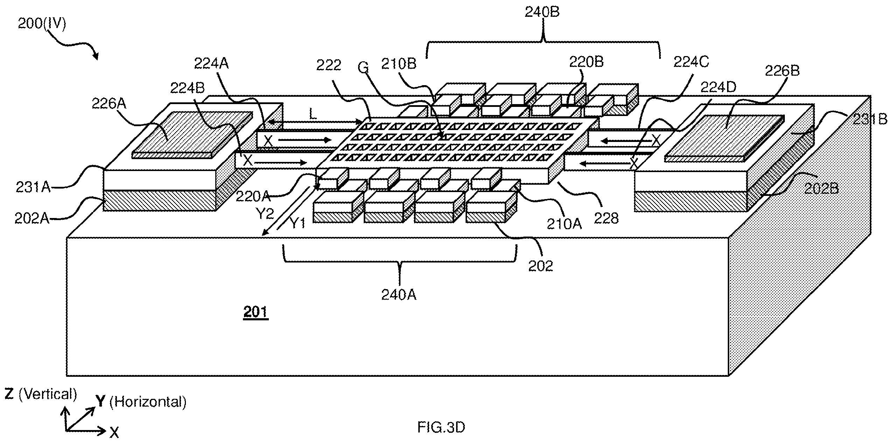

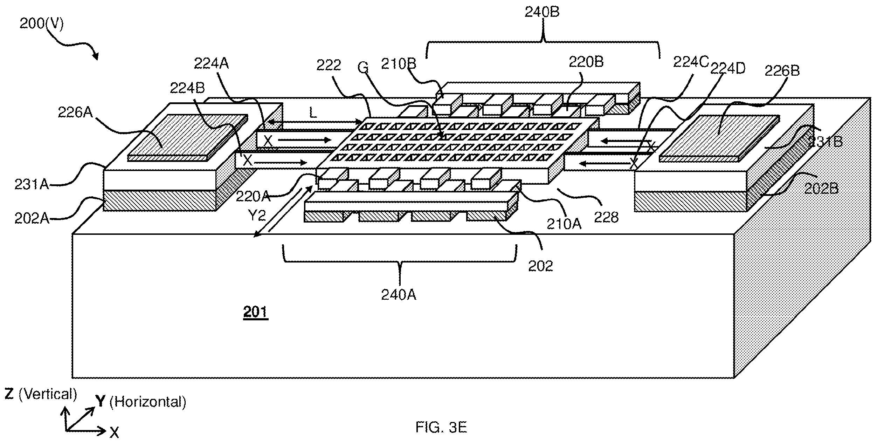

Additionally referring to **FIGS. 3D** and **3E**, a MEMD **200(IV)** and a **MEMD 200(V)** may have individual support members **231A** and **231B**.

To simplify the discussion that follows, MEMDs **200(I)** - **200(V)** are herein collectively referred to as MEMD **200**, unless the description refers to the operable differences resulting from the different coupling configurations of the conductive element.

First conductive elements **210** are electrically charged, e.g., in a controlled manner using a FGCD. Second conductive elements **220** are suspended and connected to an electrical circuit (not shown). The following description refers to a configuration in which the first conductive elements are electrically charged using a FGCD. Accordingly, the charged conductive elements are fixedly mounted, while charge is induced in the circuit through the other, inertia-mounted (second) conductive elements. The term "selectively chargeable" refers to controlled and selective electric charging of material using a FGCD).

First conductive and charged elements **210** may be fixedly arranged in an isolated manner on a carrier wafer layer **201** to operably cooperate with second conductive elements **220**. The expressions "operably cooperate" or "operably mounted" as used herein with respect to "conductive elements", as well as grammatical variations thereof, may refer to an arrangement in which the oscillating movement of one conductive element relative to a second conductive element, can induce electric current in an electrical circuit which is connected to the second conductive element, when the first conductive element is charged.

In an embodiment, first and second conductive element may be made of a Single Crystal Silicon (SCS) on insulator carry wafer. Insulator carry wafer may for example be made of oxide on silicon wafer, glass wafer and/or any other suitable material.

It should be noted that the number of first and second conductive elements **210** and **220** shown in the accompanying figures is for exemplary purposes only and should by no means to be construed as limiting.

In an embodiment, first and second conductive elements **210** and **220** may lie in the same plane. First conductive elements **210** may be rigidly mounted onto electrically isolating island layers **202** (e.g., oxide layers) in a cantilevered manner so that a portion of each one of first conductive elements **210** is extending from a proximal coupling area of the respective isolating island layers **202**. The extension part may be suspended in air in order to reduce the overall supporting oxide. The same is true for conductive element **210**, in general, as shown in **FIGS 3A** and **3E**. Such a reduction in the supporting oxide area reduces the capacitance to the substrate and reduces the area through which electron may leak (through the oxide) to the substrate. Isolating island layers **202** overlay carrying wafer layer **201** so that first conductive elements **210** are isolated from carrying wafer layer **201**, as well as from second conductive elements **220**.

First conductive elements **210** may be electrically chargeable without requiring the employment of electrets. In other words, first conductive elements **210** and, hence, MEMD **200** may be electret-free. First conductive elements **210** are selectively electrically chargeable by employing a FGCD. Electrons that may be collected by second conductive members **220** may vanish once the MEMD is connected to an electrical circuit.

In some embodiments, MEMD **200** may be configured and operative so that first conductive elements **210** are rechargeable and/or drainable. According to some embodiments, first conductive elements **210** may be selectively charged after completion of MEMD packaging and, optionally, close to the use of MEMD **200** when employing a FGCD.

In an embodiment, an inertia element **222** that holds the second conductive elements **220** may be oscillatingly coupled with a support **231**. Inertia element **222** and conductive elements **220** may together have a center of gravity G. For example, second conductive elements **220** may extend in a cantilevered manner from an inertia element **222** so that a portion of each one of second conductive elements **220** extends from a proximal coupling edge of inertia element **222**.

In an embodiment, inertia element **222** may be carried by one or more leaf-type spring elements (also "spring elements") **224**. Spring elements **224** may have a flexible length **L** allowing inertia element **222** and second conductive elements **220** to oscillate in the **Y** direction in **X-Y** plane relative to first charged and conductive elements **210** when MEMD **200** is in operation. The space between carrying wafer layer **201** and inertia element **222** and spring elements **224** may be, for example, air, inert gas or vacuum, depending on the packaging of the MEMD. In some embodiments, second conductive elements **220** may be mounted and configured so that they may oscillate in other planes than in the **Y-Z** plane relative to first conductive element **210.** For example, inertia element **222** may lie in any oscillator position in an **X-Y** plane that has the same **Z**-position, and may oscillate relative to first conductive and charged elements **210** rectilinearly in positive and negative directions **Y1** and **Y2** which may be perpendicular to the longitudinal axes **X** of spring elements **224**. In operation, the spring elements may thus flex in an "S"-fashion.

Other spring configurations than the one described herein may be employed including, for example, a folded spring. Clearly, additional or alternative suspension configurations may be used. For example, in some embodiments, an inertia structure may be suspended from one side only in a cantilever manner.

In an embodiment, one or more spring elements **224** may extend from inertia element **222** to form a bridge **228** between supports **231A** and **231B** that are respectively arranged on opposing sides of inertia element **222** on island layers **202A** and **202B** so that the inertia element is suspended by and between supports **231A** and **231B** to allow the inertia element to oscillate relative to first conductive elements **210.** For example, two spring elements **224A-224B** may extend from inertia element **222** from one side thereof and terminate in a first island **202A**. Two other spring elements **224C-224D** may extend from inertial element **222** from the other, opposite side and terminate in a second island **202B**. A pad **226** (FIGS. **2A****-3C**) or pads **226A** and **226B** (**FIGS. 3D** and **3E**) for making contact between a circuit and second conducive members **220** can be made of metal. In FIGS. **3D** and **3E** only one pad may be required to be connected to the electrical circuit.

In some embodiments, MEMD **200** may comprise one or more sets of cooperating first and second conductive elements **210** and **220**. For example, a first set of cooperating fixedly mounted conductive elements **210A** and oscillating elements **220A** may be arranged at a first side **240A** of MEMD **200** and another set of cooperating fixedly mounted first conductive elements **210B** and oscillating second conductive elements **220B** may be arranged at another, second side **240B** which is opposite the first side. First conductive elements **210A** may be, for example, arranged on individually isolating island layers **202** that are arranged along a part of first side **240A** on carrying wafer layer **201.** Further, second oscillating conductive elements **220B** may be, for example, arranged on individually isolating island layers **202** that are arranged along at least a part of first side **240B** on carrying wafer layer **201.** In some embodiments, even with two different individual supports, only one pad may be employed.

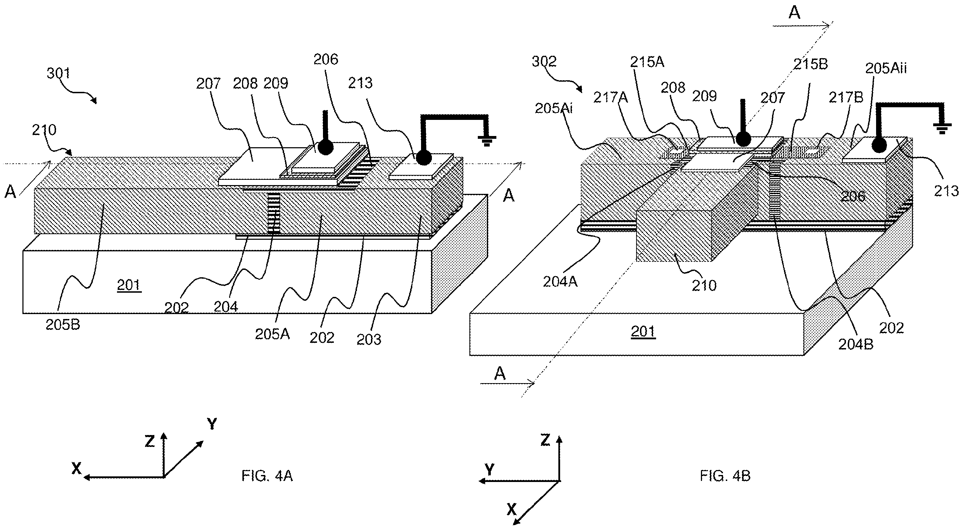

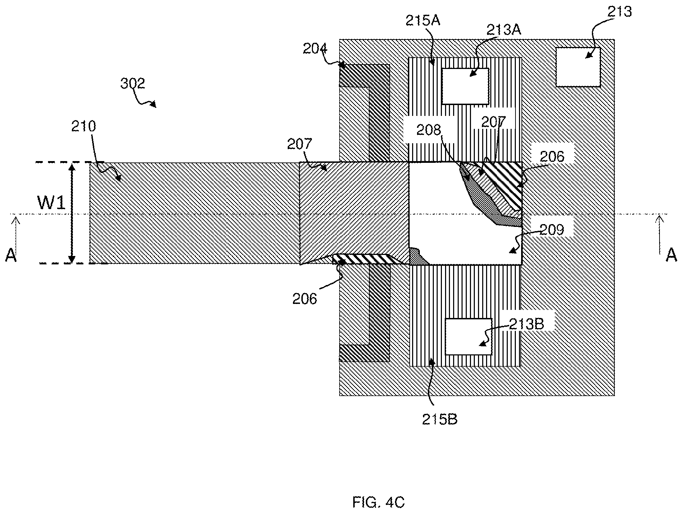

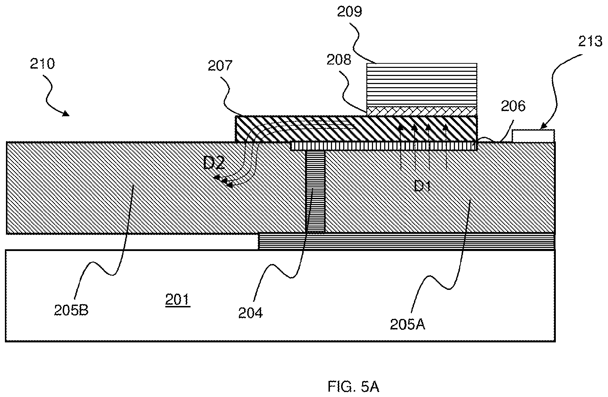

Additional reference is now made to **FIG. 4A**, which shows a schematic perspective side-view illustration of a first configuration of the FGCD **301** according to some embodiments; to **FIG. 4B**, which shows a schematic perspective front-view illustration of a second configuration of the FGCD **302**, according to some alternative embodiments; and to **FIG. 4C** which shows a schematic top plan view illustration of a charging arrangement **302.** Moreover, reference is also made to **FIGS. 5A****, FIG. 5B-1** and **FIG. 5B-2** which shows the cross section A-A indicated in **FIGS. 4A****-4C**, according to some embodiments; and to **FIGS. 6**A and **6B** which shows a schematic plan top view illustration of yet another FGCD charging arrangement, according to an alternative embodiment.

Referring to **FIG. 4A**, charging arrangement **301** may comprise an island layer **202** on carrying wafer layer **201** and a conductive layer **203** partly connected to carrying wafer layer **201** through isolated layer **202** and partly suspended. Conductive layer **203** may be divided into a proximal conductive portion **205A** and a distal conductive portion **205B** by an isolating barrier **204** which extends perpendicularly from island layer **202** up to the upper surface of conductive layer **203**. The distal conductive portion **205B** may constitute conductive element **210** (e.g., a silicon - electrode element), which may herein also be referred to as electrode **210.** Some (e.g., the majority) but not all of distal conductive portion **205B** may be suspended or cantilevered over the part of carrying wafer layer **201** which is not covered with isolating layer **202**. The upper surface of isolating barrier **204** may be in substantially the same plane as the upper surfaces of proximal and distal conductive portions **205A** and **205B**.

A tunneling oxide layer **206** may overlay a part of proximal conductive portions **205A**, extending entirely over the upper surface of isolating barrier **204** and further over a part of distal portion **205B** such that some of the distal conductive portion **205B** remains exposed. In an embodiment, the oxide beyond isolating barrier **204** (i.e. in a distal direction away from the FGCD structure) may be thicker than the tunnel oxide as no tunneling current flows beyond this point. Such a "thick" oxide may be required to improve isolation and reduce parasitic capacitance. Furthermore, a floating gate layer **207** may overlay tunnel oxide layer **206** and "spill over" the distal edge of tunnel oxide **206** to cover an additional area of the upper surface of distal conductive portion **205B**, sufficiently to create a good electrical contact that will allow electrons to flow without much resistance.

On top of floating gate **207**, a gate isolating layer **208** and a charging gate layer **209** are disposed. A reference pad **213** may be disposed over the proximal edge of the floating gate arrangement of tunnel layer **206** so that a voltage can be built up between distal gate layer **209** and reference pad **213,** allowing the tunneling condition and electrons flow for charging the floating gate **207**. It is noted that in this way the first conductive element(s) can be considered to be charged "directly", since the floating gate of the FGCD is directly coupled to and integrally formed with the first conductive element.

Floating gate layer **207** can for example be made of conductive material such that electrons tunneling into the floating gate will flow along it to conductive portion **205B**.

As shown schematically in **FIG. 4B**, a charging arrangement **302** may include a Source **215A** and Drain **215B** with electrical pads **217A** and **217B** respectively. In some embodiments, source **215A** and the drain **215B** are doped silicon with doping type that is opposite to the substrate type. That is if the substrate is P type, the S and the D are N+ type. The "+" signs indicates that the material is highly doped. Numerals **205Ai** and **205Aii** indicate the left and right portions of the T-shaped FGCD arrangement. Numerals **204A** and **204B** indicate the right/left barrier portions of the floating gate arrangement. The shading in the Figures defining the Source and the Drain are for illustrative purpose only. As in the configuration shown in **FIG. 4A**, charging Gate **209** creates a tunneling path that allows electrons to flow from the substrate to the floating gate. By applying a voltage between the source and the drain, electrons flow along a conductive channel under the tunnel oxide. Some of these electrons, called "hot" electrons because of their kinetic energy, change their direction and tunnel to the floating gate such that the charging effect is enhanced compared to a process where the charging is done only by applying a gate voltage.

As shown schematically in **FIG. 4C**, a suspended electrode (conductive element) **210** may have a width **W1** ranging, for example, from about 1 µm to about 2 µm, or of the order of several microns. Additional reference is made to **FIG. 5**A, which schematically illustrates the electron propagation path responsive to the application of a tunneling condition as a result of gate voltage. This description is also valid in case of hot electrons, in case of Source and Drain arrangement, and voltage is also applied between the source and the drain.

When a tunneling voltage is applied between gate **209** and the reference pad **213** and between the source and the drain (in case of a configuration that includes source and drain), electrons tunneled from proximal conductive portion **205A** via tunneling oxide layer **206** charging floating gate layer **207** (schematically illustrated by arrow **D1**), and, further by diffusion, to distal conductive portion **205B** of conductive element **210** (as schematically illustrated by arrow **D2**).

Reference is made to **FIGS. 5B-1** and **5B-2**. Since the field between the charging gate and the substrate is limited to their overlapping area, the electrons may concentrate there as shown schematically in **FIG. 5B-1**. When the voltage is dropped to zero and the field vanishes, the electrons may diffuse to the floating gate extension and to conductive element **210** as shown in **FIG. 5B-2**. In this case, the charging arrangement works as a charge pump, where each charging cycle pumps more electrons to charge conductive element **210**. The charge pulses may be very short so that the steps shown in **FIGS. 5B-1** and **5B-2** may take less than a second.

Upon removal of the tunneling voltage, the tunneling condition stops and no electrons can flow through the tunnel oxide. The electrons are trapped in the floating gate and then distribute throughout this conductive and isolated volume of conductive element **210**. It is reasonable to assume that to some extent the electrons will flow away from each other and thus be closer to the envelope of this volume of **205B** (element **210**). The electron concentration may be similar to that of floating gate memory and is calculated to be in the order of 10⁸-10¹⁹ electrons per cm³.

Charge may be pumped (drained) out of the element by reversing the polarity of the charging gate voltage and by using a similar cycling method

Further reference is now made to **FIG. 6A**, which illustrates schematically a charging arrangement **3021** comprising a plurality of FGCD, **310**, respective "sources" and "drains" of a floating gate extension and layer **2071** that are arranged and operable to enable the selective charging of a conductive element **2101**, through floating gate **2071** that extends to contact element **2101** according to some embodiments. In other words, a plurality of floating gates may be employed for charging a conductive element. As shown schematically in **FIG. 6**A, there is practically no limitation on the width **W2** of floating gate extension layer **2071**. Width **W2** can for example range from 0.5 µm to 100 µm or more. A barrier **2041** isolates a proximal conductive portion **2051A** from a conductive element **2101.**

Further reference is now made to **FIG. 6B**, which illustrates schematically a charging arrangement **3032** comprising a plurality of first conductive elements **210A-210C** that are charged by one FGCD that includes a source and a drain.

Further reference is made to **FIG. 7**, which illustrates schematically a sequence diagram of the behavior of charge carriers in conductive elements **210** of a MEMD according to embodiments, at different time stamps during an oscillation period.

At an initial stage t**=t0**, no external forces are applied on MEMD **200**. Responsive to subjecting MEMD **200** to external vibrational forces of sufficient magnitude, first and second oscillatingly mounted (suspended) conductive elements **220A** and **220B** may jointly move or be displaced upward to the same extent relative to fixedly mounted conductive and charged elements **210A** and **210B**. The upward movement is in a first direction, schematically illustrated by arrows **G1**. This relative movement rejects electrons in conductive element **220B**. As conductive elements **220B** and **220A** are connected to an electrical circuit, current may be induced in the circuit. Further, as indicated with respect to **t=t2**, the vibrational forces may cause inertia-mounted conductive elements **220A** and **220B** to jointly move downward relative to fixedly mounted conductive elements **210A** and **210B** in opposite direction to **G1,** which is schematically illustrated by arrows **G2**. During the downward displacement, at **t=**t**2** the position of the conductive elements may momentarily be as at **t=t0** and from there the two conductive elements move as indicated in arrow **G2** such that conductive element **220A** is in close proximity to conductive element **210A**. When at sufficient proximity electrons are rejected from element **220A** which in turn induces current in the electrical circuit. Conductive element **210A** and **210B** return to the initial position at **t=t4** and complete a full vibration cycle.

The fixedly mounted conductive elements **210A** and **210B** are negatively charged. Moreover, initially, there may be no overlap between suspended (oscillatingly) mounted conductive elements **220B** and fixedly mounted conductive elements **210A**. Therefore, there is no significant charge induced on suspended conductive elements at the initial state **T=T0**.

It is noted that overlap between the conductive elements is not necessarily a requirement for current to be induced. In some embodiments, it may suffice that the conductive elements come in sufficient proximity to each another. However, the larger the overlap at sufficient proximity the more electrons are rejected.

It is noted that in some embodiments, as exemplified herein below, a MEMD may be configured so that during an entire oscillation period fixedly and suspended conductive elements may always overlap.

Additional reference is made to **FIG. 8A** and to **FIG. 8B**. FIG. **8B**, schematically illustrates a circuit diagram **801** representing the functional electronic elements of MEMD **200** device shown in **FIGS. 3A**, **3B** and **8A**. Electrodes which are inertia-mounted are designated by reference numerals **220A-220D**. Non-inertia (i.e. fixedly) mounted conductive and charged elements are designated by reference numerals **210A-210D**. According to some embodiments, conductive elements **210A-210D** may be operably coupled with a diode bridge **250** comprising four diodes **251-254** and a load **255** of given impedance **Z**, comprising, e.g., a resistor and a capacitor coupled in parallel via electric conductive pad **226**such as to generate a DC output over load **255**.

For example, responsive to the transition from the initial stage (t=**t0**) to the first quarter of the periodic movement (t=t1) (cf. **FIG. 7**) during which inertia mounted elements **220B** move upwards and thus closer to second fixed conductive elements **210B**, electrons flow in the circuit. Since current is defined as movement of positive charge, this electron flow is equivalent to a (positive) current flowing in the opposite direction, from a reference potential which may be implemented, for example, by ground voltage, through diode **252** and through the load (e.g., resistor and capacitor) from top to bottom. From there, the current flows through diode **253** to pad **256B**. Responsive to the transition from Quarter 1 (t=**t1**) to Quarter 2 (**t=t2**) during which inertia-mounted conductive elements **220B** move back to their initial position, current flows in the opposite direction. That is, from pad **256B** through diode **251** and through the load **255** from top to bottom, and from there through diode **254** to the reference potential. Furthermore, responsive to the transition from Quarter **2** (**t=t2**) to the third quarter (**t=t3**), the suspended conductive elements move down so that the lower (first) suspended conductive elements **220A** move closer to lower (first) fixed conductive elements **210A** such that electron flow from pad **256A** to the circuit. Once again this is equivalent to positive current flowing in the opposite direction. That is, Reference potential->Diode **252**-> Load **255** from top to bottom -> Diode **253** -> Pad **265A**. Finally, responsive to the transition from Quarter 3 (**t=t3**) to Quarter 4 (**t=t4**), the conductive elements move back to their initial state causing current to flow from Pad **265A** to the reference potential in the following route: Pad **256A** -> Diode **251** - > **Load** + load **255**-> Diode **254** -> Reference. Note that the actual movement is of electrons in the opposite direction, so actually electrons flow from the reference potential to inertia-mounted conductive elements **220A** where charge is missing.

As shown in **FIG. 8A**, oscillating conductive elements **220A** may be mounted in a double-sided comb-like manner onto an inertia element **322** having a frame-shaped rim. Compared to MEMD **200** shown in **FIG. 3A** and **3B**, inertia element comprises two additional pairs of cooperating upper and lower conductive elements. As already outlined herein, the electric circuit diagram shown in **FIG. 8B** can represent the configuration of MEMD **300** shown in **FIG. 8A**.

Reference is further made to **FIG. 9A**, which schematically illustrates a combination MEMD **400** comprising a plurality of MEMDs (e.g., MEMD **4001** and **4002**) comprising reverse (mirror-like) oscillatingly mounted conductive elements according to some embodiments; and to **FIG. 9B** which schematically illustrates a circuit diagram **803** representing the functional electronic elements of MEMD **400** device shown in **FIGS. 9A**. As shown in **FIG. 9A**, inertia-mounted conductive elements of both first and second MEMDs **4001** and **4002** may be mounted in a single-sided comb-like manner onto respective inertia elements **422** and **4221** which may have a frame-shaped rim. Further, suspended conductive element **220A-220C** are mounted to oscillate in relative direction which is reverse or opposite a concurrent oscillation direction of suspended conductive elements **4201A-4201C**. In other words, fixedly mounted electrodes **210A-210C** of MEMD **4001** are operably mounted in a mirrored manner (with respect to horizontal Axis **Y**) relative to the fixedly mounted electrodes **4101A-4101C** of MEMD **4002.** Correspondingly, suspended electrodes **220A-220C** of MEMD **4001** are operably mounted in a mirrored manner (with respect to horizontal axis **Y**) relative to suspended electrodes **4201A-4201C** of MEMD **4002**. Hence, the relative oscillation direction of the suspended conductive elements of first MEMD **4001** is mirrored with respect to oscillation direction of second MEMD **4002**. For example, while suspended conductive elements **220A** move away from fixedly mounted elements **210A**, suspended conductive elements, **4201A** approach relative to fixedly mounted elements **4101A** and vice versa.

As shown schematically in **FIG. 9A**, when at rest, i.e., at an initial stage, fixedly mounted conductive elements **210** and suspended elements **220** may overlap so that charge may be induced in the suspended electrodes. Therefore, when the frames of both MEMD **4001** and **4002** move downwards, the overlapping between the suspended electrodes in upper device MEMD **4001** increases. Conversely, in lower device MEMD **4002** the two sets of electrodes retract, decreasing overlap. Additional reference is made to **FIG. 9B**, which schematically illustrates a circuit diagram **803** representing the functional electronic elements of MEMD **400** device shown in **FIG. 9A**. The two devices MEMD **4001** and **4002** are operably connected with each other. There is an initial charge induction on the suspended electrodes and therefore when the frames of the devices move down the gap between electrodes **220** and **210** in MEMD **4001** gets smaller and therefore electrons are rejected from the upper set of suspended electrodes (**220A-220C**). The downwards movement of the device increases the gap between electrodes **220** and **210** in MEMD **4002** and therefore electrons are attracted to the lower set of suspended electrodes (**4201A-4201C**). Therefore (positive) current will flow in the circuit in the following path from conductive elements **4201A-4201C** to pad **4261** to diode **252** from there to load in up to down direction. Next the current will flow from diode **253** to pad **226** and to conductive elements **220A-220C**. In the opposite relative movement, current flows in the opposite direction, from conductive elements **220A-220C** to pad **226**-to diode **251** and load from top to bottom. From there, the current flows through diode **254** and from there to conductive elements **4210A-4201C** through pad **4261**.

Reference is now made to **FIG. 10A**, which schematically illustrates MEMD **4001** alone; and to **FIG. 10B**, which schematically illustrates a circuit diagram **803** representing the functional electronic elements of MEMD **4001** device shown in **FIG. 10A**. When only one MEMD is used, the other side of the circuit can be connected to the reference potential, as illustrated schematically in **FIG. 10B**, such that current flows from and to the reference potential.

According to some embodiments, the selectively chargeable conductive elements may be made of P-type or N-type semiconductor material. As well known, the majority mobile charge carriers in N-type semiconductors are electrons and in P-type semiconductors are holes. To keep the semiconductor material electrically neutral, the electrons and holes are balanced by (respectively) positive and negative ions. In the event that P-type semiconductor material is employed, electrons that are tunneled to the conductive elements may recombine with the holes thus leaving the material charged with negatively charged ions. As a consequence, charge is less likely to move and eventually leak out of the isolated conductive element either through the tunnel oxide or through the outer surface of the charged conductive element.

Assuming for example that a conductive element **210** is 2µm wide, 10µm deep and 20µm long. The volume of the conductive element is then 4⁻¹⁰ cm³. Assuming a required charge concentration of 10¹⁸ cm⁻³, the number of electrons required is 4⁸. This means a FGCD with a charging gate **209** area of 250 µm², or for example a charging gate **209** with a size of 15 × 15µm per conductive element **210**. The charging may take place through one long charging cycle or it may take place through several charging cycles. The area of the charging **209** is inversely proportional to the charging time. That is, the larger the gate area the more electrons can tunnel through the oxide in a given time period and thus the shorter the charging time. For example, with two charging cycles, the area of charging gate **209** drops to about 125µm², i.e. to a charging gate of about 11× 11µm per conductive element **210**. In the calculation above we assume that the volume of the floating gate **207** underneath the charging gate **209** is negligible compared to element **210**.

A microelectromechanical system may comprise a plurality of MEMDs. Aspects of embodiments also relate to a method of a charging arrangement of a MEMD.

In some embodiments that do not form part of the invention and as outlined herein below in more detail, a charging arrangement may in some embodiments, act as a chemical sensor. For example, a negatively charged first conductive element **210** may attract positively charged ions and/or molecules.

Reference is made to **FIG**. **11A** and **11B**, which describe an **MEMD** in sensing mode, in which the first and second conductive elements may be fabricated one next to each other in alternating arrangement. Both conductive elements may be fixed or partly fixed to a common substrate but electrically isolated from it. After charging a first conductive element **210** of a charging arrangement **310**, such as using FGCD, the surface of conductive element **210** may attract ions or molecules **311** as shown in **FIG. 12B**. The adherence of molecules redistributes at least some of the charges in conductive element **220**. The charge redistribution may be sensed by employing an electrical circuit connected to pad **226**. For example, as schematically shown in **FIG. 11B****,** a change in measured voltage from **V1** to **V2** between the second conductive element and the reference potential may be indicative of molecule and/or ion adherence to conductive element **210**. In another embodiment, a change in measured electrical current flowing from pad **226** to the reference potential may be indicative of a value of a parameter relating to a change in an environmental condition (e.g., adherence of ions and/or molecules). In some embodiments, a sensing MEMD may be employed for attracting, e.g., in a controllable manner, molecules and/or ions.

In some embodiments, the surface of the first conductive element may be modified such that only specific molecules may adhere to it (e.g., chlorine molecule) in which case the sensing MEMD may be employed to sense the presence of a specific molecule in the environment. Reference is made to **FIG 12A** and **12B**. In a similar way to the chemical sensor described in **FIG. 11**, a conductive element can be charged for attracting, e.g., in a controllable manner, molecules and/or ions. Attracted molecules may redistribute the charge within the conductive element which in turn may cause a voltage drop or increase, depending on whether on the type or charge sign of charged adhering to the surface. As shown in FIG. **12B** and **12C** depending on the surface treatment made to the conductive element, negatively charged molecules or ions may be attracted to the element (**FIG. 12B**) or positively charged molecules or ions may be attracted to it (**FIG. 12C**). When negatively charged molecules or ions adhere to the conductive element, the voltage measured on the charging gate increases, as the concentration of electron between the charging gate and the floating gate increases. When positively charged molecules or ions adhere to the conductive element the electron they attract electron away from the gate area and therefore the concentration of electrons between the charging gate and the floating gate decreases and the voltage drops.

Additional reference is made to **FIG. 13** that describes a displacement sensor. **FIG. 13** is similar to embodiment shown in FIG. **8A** but is not limited to it. The only difference is the measuring circuit connected to the second conductive element. In FIG. **8B** the device is connected to a rectifying circuit while in **FIG. 13** the device may be connected to a circuit that measures the voltage change between the pad **226** and the reference potential. The change in the voltage may be results from relative movement between first conductive elements **210A-210D** and second conductive elements **220A-220D**. Such relative movement may for example be the results of vibration, acceleration or other forces such as Coriolis forces acting on the MEMD. In the embodiment of **FIG. 13** the device is an acceleration displacement sensor.

It is noted that all of the embodiment discussed above in reference to energy harvesting may be applied to acceleration sensor either by using the same rectifying circuit or by using a different electrical circuit, such as the circuit shown in **FIG. 13**, to translate the relative displacement between conductive elements **210** and **220** into an electrical signal. It also clear that an electrical amplifier may be used to amplify the signal in a sensing configuration of the embodiments above.

Reference is made to **FIG. 14**. A method for manufacturing a charging arrangement may include providing a SOI wafer **2000** comprising a Between Oxide Layer (BOX) **2100** interposed between an upper silicon layer called the device layer **2200** and lower Silicon carrier wafer **2300**.

As shown schematically in **FIG. 15**, the method may then include providing, e.g., aSi₃N₄ coating for preventing oxidation underneath it, as in **FIG. 18****.**

As shown schematically in **FIG. 16**, the method may further include forming a U-shaped trench **2250** extending in wafer **2000** all across device layer **2200** down to the upper side of the oxide layer **2100**, by employing for example photolithography for pattern transfer, which may be followed by, e.g., Deep Reactive Ion Etching (DRIE) of the device layer down to the oxide layer **2100**.

As shown schematically in **FIG. 17**, the method may include performing thermal oxidation of the wafer such that the inner surface of U-shaped trench **2250** is filled with oxide. It is noted that other filling materials may be used.

As shown schematically in **FIG. 18**, the method may further include employing a manufacturing process for obtaining a FGCD that is integrated with first conductive element **210**. **FIG. 18** shows in (a) a breakdown of the process. The integrated FGCD process may include patterning the Si3N4 layer in FIG. 15 to expose Silicon and an oxidation step that oxidizes the exposed Silicon to form the tunnel oxide **206** such that oxidation extends beyond the insulating barrier **2250**. Next the floating gate **207** is deposited and patterned such that it extends beyond the tunnel oxide **206** and makes an ohmic contact with the silicon beyond the tunnel oxide.

The use of insulating barrier **2250**, and the specific patterning the tunnel oxide and the floating gate are unique to the proposed process and are not common in state of the art FGCD technology. Source **215A** and Drain **215B** steps may follow by doping the areas on the two sides of the floating gate. An insulating layer **208** and a charging gate **209** are deposited and patterned to complete the FGCD step.

The method may include deposition and patterning of pads **217A** and **217B** as shown in **FIG. 18** (b). The pad metallization comes last in the FGCD process.

As shown schematically in **FIG. 19**, the method may include employing photolithography, image transfer and DRIE down to the BOX such to obtain first conductive member **210**.

As shown schematically in **FIG. 20**, the method may then include removal of the BOX.

Reference is now made to **FIG. 21****,** which describes another example of a fabrication process of the MEMD. **FIG. 21** is a side view showing one first fixed conductive element **210** fabricated in one wafer such as discussed in different embodiments. One floating gate charging device is fabricated on a second wafer **216**. When the two wafers are bonded to each other, a contact such as eutectic contact, is formed between pads **217A** and **217B**, forming an electrical contact between the floating gate **207** and element **210**.

Other processes may be used including, for example, a process that includes an etch from the back side of substrate **201**, in selective places, all the way to oxide **202,** followed by an etch of this oxide to release suspended elements **220**. It is also noted that instead of using SOI wafers, Silicon on Glass (SOG) wafers may be used.

It is further noted that the microfabrication processes described above are just examples of many possible process flows.

In the discussion, unless otherwise stated, adjectives such as "substantially" and "about" that modify a condition or relationship characteristic of a feature or features of an embodiment of the invention, are to be understood to mean that the condition or characteristic is defined to within tolerances that are acceptable for operation of the embodiment for an application for which it is intended.

Positional terms such as "upper", "lower" "right", "left", "bottom", "below", "lowered", "low", "top", "above", "elevated", "high", "vertical" and "horizontal" as well as grammatical variations thereof as may be used herein do not necessarily indicate that, for example, a "bottom" component is below a "top" component, or that a component that is "below" is indeed "below" another component or that a component that is "above" is indeed "above" another component as such directions, components or both may be flipped, rotated, moved in space, placed in a diagonal orientation or position, placed horizontally or vertically, or similarly modified. Accordingly, it will be appreciated that the terms "bottom", "below", "top" and "above" may be used herein for exemplary purposes only, to illustrate the relative positioning or placement of certain components, to indicate a first and a second component or to do both. Further, directional terms such as "upwards" and "downwards" as used herein may indicate relative movement.

"Coupled with" means "coupled with directly or indirectly".

It is important to note that the method is not limited to those diagrams or to the corresponding descriptions. For example, the method may include additional or even fewer processes or operations in comparison to what is described herein. In addition, embodiments of the method are not necessarily limited to the chronological order as illustrated and described herein.

It should be understood that where the claims or specification refer to "a" or "an" element, such reference is not to be construed as there being only one of that element.

In the description and claims of the present application, each of the verbs, "comprise" "include" and "have", and conjugates thereof, are used to indicate that the object or objects of the verb are not necessarily a complete listing of components, elements or parts of the subject or subjects of the verb.

Unless otherwise stated, the use of the expression "and/or" between the last two elements of a list of options for selection indicates that a selection of one or more of the listed options is appropriate and may be made.

It is noted that the term "perspective view" as used herein may also refer to an "isometric view".

It is appreciated that certain features of the invention, which are, for clarity, described in the context of separate embodiments or example, may also be provided in combination in a single embodiment. Conversely, various features of the invention, which are, for brevity, described in the context of a single embodiment, may also be provided separately or in any suitable sub-combination or as suitable in any other described embodiment of the invention. Certain features described in the context of various embodiments are not to be considered essential features of those embodiments, unless the embodiment is inoperative without those elements.

## Claims

1. A micro-electromechanical device, MEMD (200, 300, 400, 4001-4002), for sensing and for harvesting electrical energy responsive to being subjected to mechanical forces, comprising:
a) at least one first conductive element (210A-D, 4101A-C) fixedly mounted on a first support (202), wherein the at least one first conductive element (210A-D, 4101A-C) is chargeable with electrons; and
b) at least one second conductive element (220A-D, 4201A-C) which is inertia-mounted on a second support (222, 231, 231A, 231B) such that the first (202) and second supports (222, 231, 231A, 231B) are electrically isolated from each other;
c) a floating gate charging device, FGCD (301-302), having a tunnel oxide (206), the floating gate charging device (301-302) used for charging the at least one first fixedly mounted conductive element (210A-D, 4101A-C) selectively and controllably by tunneling electrons through the tunnel oxide (206) into the at least one first fixedly mounted conductive element (210A-D, 4101A-C);
wherein the micro-electromechanical device is **characterized by** further comprising:
d) an electronic circuit operably coupled with the at least one inertia-mounted second conductive element (220A-D, 4201A-C) for reading out charge displacement in the at least one second conductive element (220A-D, 4201A-C) resulting from relative movement between the at least one first conductive element (210A-D, 4101A-C) and the at least one second conductive element (220A-D, 4201A-C).

2. The MEMD (200, 300, 400, 4001-4002) of claim 1, wherein the FGCD (301-302) further comprises a source (215A) and drain (215B) for tunneling hot electrons to a floating gate (207, 2071) of the FGCD responsive to applying a voltage between the source and the drain.

3. The MEMD (200, 300, 400, 4001-4002) of claims 1 or 2, wherein the FGCD (301-302) has a charging polarity and a discharging polarity, wherein the discharging polarity is used to drain (215B) the electrons out of the at least one first fixedly mounted conductive element (210A-D, 4101A-C).

4. The MEMD (200, 300, 400, 4001-4002) of claims 1 or 2, comprising a plurality of FGCDs (301-302) such that each FGCD (301-302) charges one or more first fixedly mounted conductive elements (210A-D, 4101A-C).

5. The MEMD (200, 300, 400, 4001-4002) of claims 1 or 2, comprising a plurality of first fixedly mounted conductive elements (210A-D, 4101A-C) that are electrically isolated from each other.

6. The MEMD (200, 300, 400, 4001-4002) of claims 1 or 2, comprising a plurality of first fixedly mounted conductive elements (210A-D, 4101A-C) electrically conductively coupled with each other.

7. The MEMD (200, 300, 400, 4001-4002) of claims 1 or 2, wherein the induced electrons displacement is rectified for the charging of a battery or the powering of an electrical device.

8. The MEMD (200, 300, 400, 4001-4002) of claims 1 or 2, wherein the induced electrons displacement is measured for obtaining a value indicative of a displacement of the MEMD (200, 300, 400, 4001-4002).

9. The MEMD (200, 300, 400, 4001-4002) of claims 1 or 2, wherein the at least one first fixedly mounted conductive element (210A-D, 4101A-C) is highly doped with Donors atoms to form a N type silicon.

10. The MEMD (200, 300, 400, 4001-4002) of claims 1 or 2, wherein the at least one first fixedly mounted conductive element (210A-D, 4101A-C) is highly doped with Acceptors atoms to form a P type silicon such that the charging electrons recombine with holes such that the first fixedly mounted conductive element (210A-D, 4101A-C) is charged by negatively charged Acceptor ions.

11. A method of fabricating a MEMD (200, 300, 400, 4001-4002) according to claims 1 or 2, wherein the at least one first fixedly mounted conductive element (210A-D, 4101A-C), the at least one second inertia-mounted conductive element (220A-D, 4201A-C) and the FGCD (301-302) are fabricated on a single wafer (216, 2000, 2300) such that first fixedly mounted conductive element (210A-D, 4101A-C), the at least one second conductive inertia-mounted element (220A-D, 4201A-C) and the FGCD (301-302) are electrically isolated from each other while the floating gate (207, 2071) of FGCD (301-302) is electrically coupled with the first fixedly mounted conductive element (210A-D, 4101A-C).

12. A method for charging an MEMD (200, 300, 400, 4001-4002) according to claims 1 or 2, wherein the charging or discharging includes a plurality of charging or discharging cycles, such that each charging or discharging may take less than one second.

## Patentansprüche

1. Eine mikroelektromechanische Vorrichtung, MEMD (200, 300, 400, 4001-4002), zum Erfassen und Sammeln elektrischer Energie als Reaktion auf mechanische Beanspruchungen, umfassend:
a) mindestens ein erstes leitfähiges Element (210A-D, 4101A-C), das fest auf einem ersten Träger (202) angebracht ist, wobei mindestens ein erstes leitfähiges Element (210A-D, 4101A-C) mit Elektronen belastbar ist; und
b) mindestens ein zweites leitfähiges Element (220A-D, 4201A-C), das auf einem zweiten Träger (222, 231, 231A, 231B) auf Grund der Trägheit angebracht ist, so dass der erste Träger (202) und der zweite Träger (222, 231, 231A, 231B) elektrisch voneinander isoliert sind;
c) eine Floating-Gate-Ladevorrichtung, FGCD (301-302), mit einem Tunneloxid (206), wobei die Floating-Gate-Ladevorrichtung (301-302) zum Laden mindestens eines ersten fest angebrachten leitfähigen Elements (210A-D, 4101A- C) selektiv und steuerbar durch Tunneln von Elektronen durch das Tunneloxid (206) in mindestens ein erstes fest angebrachtes leitfähiges Element (210A-D, 4101A-C) verwendet wird;
wobei die mikroelektromechanische Vorrichtung **dadurch gekennzeichnet ist, dass** sie ferner umfasst:
d) eine elektronische Schaltung, die mit dem mindestens einen auf Grund der Trägheit angebrachten zweiten leitfähigen Element (220A-D, 4201A-C) betriebsfähig gekoppelt ist, um eine Ladungsverschiebung in dem mindestens einen zweiten leitfähigen Element (220A-D, 4201A-C) auszulesen, die aus der relativen Bewegung zwischen dem mindestens einen ersten leitfähigen Element (210A-D, 4101A-C) und dem mindestens einen zweiten leitfähigen Element (220A-D, 4201A-C) resultiert.

2. Die MEMD (200, 300, 400, 4001-4002) nach Anspruch 1, **dadurch gekennzeichnet, dass** die FGCD (301-302) ferner ein Quell (215A) und einen Drain (215B) zum Tunneln heißer Elektronen zu einem floatendem Gate (207, 2071) der FGCD als Reaktion auf das Anlegen einer Spannung zwischen dem Quell und dem Drain umfasst.

3. Die MEMD (200, 300, 400, 4001-4002) nach Anspruch 1 oder 2, **dadurch gekennzeichnet, dass** die FGCD (301-302) eine Ladepolarität und eine Entladepolarität umfasst, wobei die Entladepolarität verwendet wird, um die Elektronen (215B) aus dem mindestens einen ersten fest angebrachten leitfähigen Element (210A-D, 4101A-C) abzuleiten.

4. Die MEMD (200, 300, 400, 4001-4002) nach Anspruch 1 oder 2, **dadurch gekennzeichnet, dass** die eine Vielzahl von FGCD (301-302) umfasst, so dass jede FGCD (301-302) ein oder mehrere erste fest angebrachte leitfähige Elemente (210A-D, 4101A-C) lädt.

5. Die MEMD (200, 300, 400, 4001-4002) nach Anspruch 1 oder 2, **dadurch gekennzeichnet, dass** die eine Vielzahl von ersten fest angebrachten leitfähigen Elementen (210A-D, 4101A-C), die elektrisch voneinander isoliert sind, umfasst.

6. Die MEMD (200, 300, 400, 4001-4002) nach Anspruch 1 oder 2, **dadurch gekennzeichnet, dass** die eine Vielzahl von ersten fest angebrachten leitfähigen Elementen (210A-D, 4101A-C), die elektrisch leitend miteinander gekoppelt sind, umfasst.

7. Die MEMD (200, 300, 400, 4001-4002) nach Anspruch 1 oder 2, **dadurch gekennzeichnet, dass** die induzierte Elektronenverschiebung zum Laden einer Batterie oder zum Betreiben einer elektrischen Vorrichtung gleichgerichtet wird.

8. Die MEMD (200, 300, 400, 4001-4002) nach Anspruch 1 oder 2, **dadurch gekennzeichnet, dass** die induzierte Elektronenverschiebung gemessen wird, um einen Wert zu erhalten, der eine Verschiebung der MEMD (200, 300, 400, 4001-4002) anzeigt.

9. Die MEMD (200, 300, 400, 4001-4002) nach Anspruch 1 oder 2, **dadurch gekennzeichnet, dass** das mindestens eine erste fest angebrachte leitfähige Element (210A-D, 4101A-C) sehr mit Donatoratomen dotiert ist, um ein Silizium vom N-Typ zu bilden.

10. Die MEMD (200, 300, 400, 4001-4002) nach Anspruch 1 oder 2, **dadurch gekennzeichnet, dass** das mindestens eine erste fest angebrachte leitfähige Element (210A-D, 4101A-C) sehr mit Akzeptoratomen dotiert ist, um ein Silizium vom P-Typ zu bilden, so dass die Ladungselektronen mit Löchern rekombinieren, so dass das erste fest angebrachte leitfähige Element (210A-D, 4101A-C) durch negativ geladene Akzeptorionen aufgeladen wird.

11. Ein Verfahren zum Herstellen einer MEMD (200, 300, 400, 4001-4002) nach Anspruch 1 oder 2, wobei das mindestens eine erste fest angebrachte leitfähige Element (210A-D, 4101A-C), das mindestens eine zweite auf Grund der Trägheit angebrachte leitfähige Element (220A-D, 4201A-C) und die FGCD (301-302) auf einem einzigen Wafer (216, 2000, 2300) hergestellt sind, so dass das erste fest angebrachte leitfähige Element (210A-D, 4101A-C), das mindestens eine zweite leitfähige auf Grund der Trägheit angebrachte Element (220A-D, 4201A-C) und die FGCD (301-302) elektrisch voneinander isoliert sind, wobei das floatende Gate (207, 2071) der FGCD (301-302) elektrisch mit dem ersten fest angebrachten leitfähigen Element (210A-D, 4101A-C) gekoppelt ist.

12. Ein Verfahren zum Laden einer MEMD (200, 300, 400, 4001-4002) nach Anspruch 1 oder 2, wobei das Laden oder das Entladen eine Vielzahl von Lade- oder Entladezyklen umfasst, so dass jedes Laden oder Entladen weniger als eine Sekunde dauern kann.

## Revendications

1. Un dispositif micro-électromécanique, DMEM (200, 300, 400, 4001-4002), pour détecter et pour récupérer de l'énergie électrique en réponse à la soumission aux forces mécaniques, comprenant:
a) au moins un premier élément conducteur (210A-D, 4101A-C) monté de manière fixe sur un premier support (202), dans lequel un au moins le premier élément conducteur (210A-D, 4101A-C) peut être chargé par électrons; et
b) au moins un deuxième élément conducteur (220A-D, 4201A-C) qui est monté par inertie sur un deuxième support (222, 231, 231A, 231B) de sorte que le premier support (202) et les deuxièmes supports (222, 231, 231A, 231B) sont isolés électriquement l'un des autres;
c) un dispositif de chargement à gâchette flottante, DCGF (301-302), ayant un oxyde tunnel (206), le dispositif de chargement à gâchette flottante (301-302) étant utilisé sélectivement et de manière contrôlable pour charger au moins un premier élément conducteur (210A-D, 4101A- C) monté de manière fixe, en tunnelisant des électrons à travers l'oxyde tunnel (206) dans un au moins le premier élément conducteur (210A-D, 4101A-C) monté de manière fixe;
dans lequel le dispositif micro-électromécanique est **caractérisé en ce qu'**il comprend en outre:
d) un circuit électronique couplé de manière opérationnelle avec un au moins le deuxième élément conducteur (220A-D, 4201A-C) monté par inertie pour lire le déplacement de charge dans un au moins le deuxième élément conducteur (220A-D, 4201A-C) résultant d'une mouvement entre un au moins le premier élément conducteur (210A-D, 4101A-C) et un au moins le second élément conducteur (220A-D, 4201A-C).

2. Le DMEM (200, 300, 400, 4001-4002) selon la revendication 1, dans lequel le DCGF (301-302) comprend en outre une source (215A) et un drain (215B) pour tunneliser des électrons chauds vers la gâchette flottante (207, 2071) du DCGF sensible à l'application de voltage entre la source et le drain.

3. Le DMEM (200, 300, 400, 4001-4002) selon la revendication 1 ou 2, dans lequel le DCGF (301-302) a une polarité de chargement et une polarité de déchargement, dans lequel la polarité de déchargement est utilisée pour drainer (215B) des électrons hors du un au moins le premier élément conducteur (210A-D, 4101A-C) monté de manière fixe.

4. Le DMEM (200, 300, 400, 4001-4002) selon la revendication 1 ou 2, comprenant une pluralité de DCGF (301-302) de sorte que chaque DCGF (301-302) charge un ou plusieurs premiers éléments conducteurs (210A-D, 4101A-C) montés de manière fixe.

5. Le DMEM (200, 300, 400, 4001-4002) selon la revendication 1 ou 2, comprenant une pluralité de premiers éléments conducteurs (210A-D, 4101A-C) montés de manière fixe qui sont électriquement isolés les uns des autres.

6. Le DMEM (200, 300, 400, 4001-4002) selon la revendication 1 ou 2, comprenant une pluralité de premiers éléments conducteurs (210A-D, 4101A-C) montés de manière fixe qui sont électriquement et conductivement couplés les uns aux autres.

7. Le DMEM (200, 300, 400, 4001-4002) selon la revendication 1 ou 2, dans lequel le déplacement induit des électrons est redressé pour chargement d'une batterie ou l'alimentation d'un appareil électrique.

8. Le DMEM (200, 300, 400, 4001-4002) selon la revendication 1 ou 2, dans lequel le déplacement induit des électrons est mesuré pour obtenir une valeur indicative d'un déplacement du DMEM (200, 300, 400, 4001-4002) .

9. Le DMEM (200, 300, 400, 4001-4002) selon la revendication 1 ou 2, dans lequel un au moins le premier élément conducteur (210A-D, 4101A-C) monté de manière fixe est fortement dopé avec des atomes donneurs pour former un silicium de type N.

10. Le DMEM (200, 300, 400, 4001-4002) selon la revendication 1 ou 2, dans lequel un au moins le premier élément conducteur (210A-D, 4101A-C) monté de manière fixe est fortement dopé avec des atomes accepteurs pour former un silicium de type P de sorte que les électrons de chargement se recombinent avec des trous de sorte que le premier élément conducteur (210A-D , 4101A-C) monté de manière fixe est chargé par ions accepteurs chargés négativement.

11. Un procédé de fabrication d'un DMEM (200, 300, 400, 4001-4002) selon les revendications 1 ou 2, dans lequel un au moins le premier élément conducteur (210A-D, 4101A-C) monté de manière fixe, un au moins le deuxième élément conducteur (220A-D, 4201A-C) monté par inertie et le DCGF (301-302) sont fabriqués sur une seule galette wafer (216, 2000, 2300) de sorte que le premier élément conducteur (210A-D, 4101A-C) monté de manière fixe, un au moins le second élément conducteur monté par inertie (220A-D, 4201A-C) et le DCGF (301-302) sont isolés électriquement l'un des autres, tandis que la gâchette flottante (207, 2071) du DCGF (301-302) est électriquement couplée au premier élément conducteur (210A-D, 4101A-C) monté de manière fixe.

12. Procédé de chargement d'un DMEM (200, 300, 400, 4001-4002) selon les revendications 1 ou 2, dans lequel le chargement ou le déchargement comprend une pluralité de cycles de chargement ou de déchargement, de sorte que chaque chargement ou déchargement peut prendre moins d'une seconde.
